Europäisches Patentamt

European Patent Office

Office européen des brevets

(11) Publication number: **0 082 012**
**B1**

## (12) EUROPEAN PATENT SPECIFICATION

(45) Date of publication of patent specification: **24.02.88**

(21) Application number: **82306670.9**

(22) Date of filing: **14.12.82**

(51) Int. Cl.⁴: **H 01 L 23/48**

(54) Multilayer electrode of a semiconductor device.

(30) Priority: **16.12.81 JP 204070/81**

(43) Date of publication of application:
**22.06.83 Bulletin 83/25**

(45) Publication of the grant of the patent:
**24.02.88 Bulletin 88/08**

(84) Designated Contracting States:
**DE FR GB**

(56) References cited:
**US-A-3 567 509**
**US-A-3 881 971**
**US-A-3 918 149**
**US-A-3 939 047**

**IBM TECHNICAL DISCLOSURE BULLETIN, Vol. 19, No. 9, February 1977, page 3382, NEW YORK, (US) P.L. GARBARINO et al.: "Contact barrier metallurgy for MOSFET gate".**

**IBM TECHNICAL DISCLOSURE BULLETIN Vol. 19, No. 8, January 1977, page 3233, NEW YORK, (US) F.M. D'HEURLE et al.: "Metallization for shallow junction silicon technology".**

(73) Proprietor: **FUJITSU LIMITED**
**1015, Kamikodanaka Nakahara-ku**
**Kawasaki-shi Kanagawa 211 (JP)**

(72) Inventor: **Takeuchi, Toru G.H.**
**31-203, 6205-6 Izumi-cho Totsuka-ku**
**Yokohama-shi Kanagawa 245 (JP)**
Inventor: **Fujita, Ichiro**
**5-5-301 Matsugae-cho**
**Sagamihara-shi Kanagawa 228 (JP)**
Inventor: **Ono, Toshihiko**
**2845-7 Arima Miyamae-ku**
**Kawasaki-shi Kanagawa 240 (JP)**
Inventor: **Watanabe, Kiyoshi**
**Adachi-so 1-13-6 Midorigaoka**
**Meguro-ku Tokyo 152 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## 0 082 012

**Description**

The present invention relates to a semiconductor device and in particular, it relates to a multilayer electrode in which a conductor layer contacts a semi-conductor substrate via a window in an insulating layer.

Aluminium or an aluminium alloy is generally used for forming electrodes and wiring of a semiconductor device, such as an integrated circuit or a large-scale integrated circuit. Aluminium has merits of a low electric resistance and a low contact resistance to the silicon of a semiconductor substrate. However, aluminium can be alloyed with silicon so that the silicon of the semiconductor substrate dissolves into the aluminium of the electrode formed on the semiconductor substrate during annealing steps or heating steps carried out in the packaging process. As a result of the dissolution of the silicon into the aluminium, i.e. the alloying of aluminium with silicon, the characteristics of a Schottky barrier diode and a bipolar transistor deteriorate. In extreme cases shallow emitter PN junctions may be broken by such aluminium-silicon alloying to form permanent emitter-base short-circuits.

To overcome this problem Japanese patent specification JP—A—54-44866 describes a multilayer construction for an electrode consisting of a first layer of aluminium a second layer of a refractory metal or a refractory metal alloy, and a third layer of aluminium. This construction limits the extent of the solution of the aluminium into the silicon provided the temperatures used in the preparation of the device are kept below 450°C. However, above this temperature the second layer no longer acts as a barrier and consequently this construction is not effective in controlling the dissolution of the aluminium and silicon above this temperature.

Thus the aim of the present invention is to provide a semiconductor device which does not deteriorate when the device is heated to a temperature higher than 450°C and, for example to a temperature of approximately 500°C.

According to this invention a multilayer electrode of semiconductor device comprising a first layer containing aluminium in contact with the surface of a silicon semiconductor substrate, a second layer of a refractory metal or an alloy or compound thereof formed on the first layer, and a third layer containing aluminium formed on the second layer is characterised in that the third layer also contains silicon.

Particular examples of semiconductor devices including multilayer electrodes in accordance with this invention will now be described and contrasted with the prior art with reference to the accompanying drawings; in which:—

Figure 1 is a section through part of a semiconductor device illustrating a multilayer electrode in contact with a silicon semiconductor substrate, this Figure is used both to discuss the prior art and the present invention;

Figures 2A to 2C are sections through part of a semiconductor device in various stages in its production;

Figure 3 is a graph showing the relationship between the thickness of the TiW layer and the occurrence of emitter-base short-circuiting;

Figure 4 is a graph showing the relationship between the thickness of the TiW layer and the forward voltage of the Schottky barrier diode; and,

Figures 5 to 7 are graphs showing the relationship between the contact area of a Schottky barrier diode and the forward voltage of the Schottky barrier diode with various multilayer electrodes.

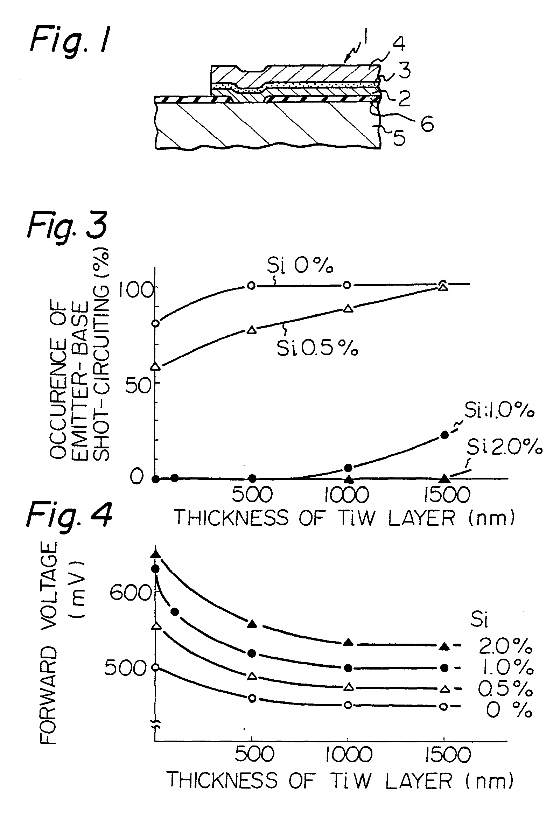

In the past, a multilayer (e.g. a triple-layer) electrode 1 comprised a first aluminium layer 2, a second layer of a refractory metal (such as Ti, W, or Mo) or of an alloy thereof (such as TiW) 3, and a third aluminium layer 4. The first aluminium layer 2 of the multilayer electrode 1 contacts the surface of a silicon substrate 5 via a window (i.e. a contact hole) formed in an insulating layer 6 made of silicon dioxide or phospho-silicate glass. This construction is illustrated with reference to Figure 1 and is described in Japanese unexamined Patent Publication (Kokai) No. 54-44866. Such a construction of the multilayer electrode is based upon the fact that Ti, W and TiW do not easily react with aluminium or silicon. Since the second layer 3 of the refractory metal is interposed between the first aluminium layer 2 and the third aluminium layer 4 and serves as a barrier layer, only the first aluminium layer 2 can react with the silicon of the substrate 5. Therefore, the degree to which the silicon dissolves into the aluminium is limited to a predetermined amount.

Since an electrode of a semiconductor device is manufactured so that it has the above-mentioned multilayer structure in order to prevent excessive dissolution of the silicon of the semiconductor substrate into the aluminium of the electrode, it is possible to carry out annealing and heating without deteriorating the characteristics of the semiconductor device, provided the annealing and the heating are carried out at a temperature lower than approximately 450°C. At present, however, it is preferable to make the semiconductor device withstand a temperature of approximately 500°C. For example, in the case of a ceramic dual inline package, the die bonding step is performed at a temperature of from 400 to 450°C and the sealing step is performed at a temperature of from 420°C to 480°C. At a temperature of 500°C however, the function of the barrier of the second layer of the multilayer electrode of the above-mentioned structure, which function is to inhibit the reaction between the aluminium and the silicon, is lost. Therefore, the silicon excessively dissolves into not only the first aluminium layer but also the third aluminium layer, thereby deteriorating the characteristics of the semiconductor device.

2

According to the present invention which will also be described with reference to Figure 1, multilayer electrode 1 of a semiconductor device comprises a first layer 2 of aluminium, a second layer 3 of a refractory metal, refractory metal alloy or refractory metal compound and a third layer 4 of an aluminium-silicon alloy, as illustrated in Figure 1. The first layer 2 contacts the surface of a silicon semiconductor substrate 5 through a window formed in an insulating layer 6. The contact between the first layer 2 and the silicon substrate 5 forms a Schottky barrier or ohmic contact, depending upon the concentration of the impurities introduced into the silicon substrate 5.

The aluminum-silicon alloy of the third layer 4 contains from 0.5% to 2.0% by weight of silicon, preferably from 0.8% to 1.5% by weight of silicon. It is preferable that the third layer 4 has a thickness of more than 500 nm so as to decrease the electric resistance of the electrode 1.

The aluminum of the first layer 2 may be alloyed with the silicon substrate when it is formed. As a result, the amount of silicon of the silicon substrate 5 which dissolves into the aluminum of the multilayer electrode 1 can decrease somewhat. The thickness of the first layer 2 generally is from 50 to 200 nm.

The refractory metal of the second layer 3 is either Ti, W, Mo, Zr, Cr, Hf, Nb, V, Ni, Pt, Ta, or Pd. It is possible to use an alloy of or a compound of the refractory metal for forming the second layer 3. The alloy of the refractory metal is preferably TiW, TiMo, or TiTa, and the compound of the refractory metal is preferably TiN, TaN, ZrN, WN, TiC, TaC, or HfN. The thickness of the second layer 3 is from 10 to 150 nm, preferably from 80 to 120 nm. When the second layer 3 has a thickness of less than 10 nm, nonuniformity of the layer thickness becomes relatively large. Accordingly, the function of barrier of the second layer 3 may be lost locally. If the thickness of the second layer 3 exceeds 150 nm, the electric resistance of the multilayer electrode 1 increases.

It is possible to make the first layer 2 and the third layer 4 of an aluminum-silicon-copper alloy containing, e.g., 4% by weight of copper, or an aluminum-silicon-magnesium containing, e.g. 0.5% by weight of magnesium. The inclusion of copper or magnesium in the alloy contributes to the prevention of electromigration.

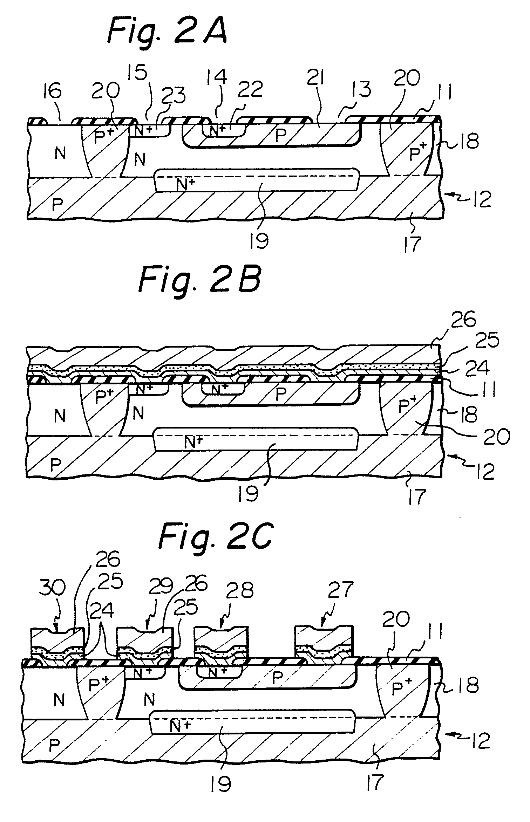

The formation of multilayer electrodes of a bipolar transistor and a Schottky barrier diode of a semiconductor device is explained with reference to Figs. 2A through 2C.

In accordance with a conventional process of producing a bipolar transistor, an insulating layer 11 of silicon dioxide covering the surface of a silicon semiconductor substrate 12 is selectively etched to form a base electrode window 13, an emitter electrode window 14, a collector electrode window 15, and a Schottky electrode window 16, as illustrated in Fig. 2A. The silicon substrate 12 consists of silicon wafer 17 and a silicon epitaxial layer 18 grown on the silicon wafer 17. A buried layer 19 is formed between the silicon wafer 17 and the epitaxial layer 18, and an isolation region 20 is formed in the silicon epitaxial layer 18. In a portion of the silicon epitaxial layer 18 surrounded by the isolation region 20, a base region 21 (having a depth of 0.9 µm), an emitter region 22 (having a depth of 0.7 µm), and a collector contact region 23 are formed.

On the silicon dioxide layer 11 and on the exposed surfaces of the silicon epitaxial layer 18 within the windows 13, 14, 15, and 16, a first layer 24 (having a thickness of 100 nm), a second layer 25 (having a thickness of 100 nm), and a third layer 26 (having a thickness of 650 nm) are formed in sequence as illustrated in Fig. 2B, by means of, e.g., a conventional sputtering method.

In the case of the prior art, the first layer 24 is made of aluminum, the second layer 25 is made of a refractory metal, and the third layer 26 is made of aluminum. While, in the present invention, the first layer 24 and the second layer 25 may be made of the same material as the first layer 24 and the second layer 25, respectively, of the prior art, i.e., aluminum and a refractory metal, respectively, and the third layer 26 is made of an aluminum-silicon alloy.

A photoresist layer (not shown) is applied on the third layer 26 and is patterned. The third, second, and first layers 26, 25, and 24 are selectively etched by a conventional dry-etching method, using the patterned photoresist layer as a mask to form a base electrode 27, an emitter electrode 28, a collector electrode 29, and a Schottky electrode 30, as illustrated in Fig. 2C. A reaction gas, such as $CCl_4$, $BCl_3$, and/or $Cl_2$, can be used in the dry-etching method. After etching is carried out, the edge pattern of the electrodes including the aluminum third layer of the prior art shows a very small zigzag while that of the electrodes including the aluminum-silicon alloy third layer of the present invention is linear.

The heat resistance of a semiconductor device having the multilayer electrode of the present invention was examined in the following manner.

Multilayer electrodes consisting of a first layer 24 of aluminum, a second layer 25 of Ti, and a third layer 26 of an aluminum-silicon alloy (silicon 1%) were formed in accordance with the above-mentioned formation process. The multilayer electrodes were annealed in a nitrogen atmosphere for a period of 30 minutes at temperatures of 450°C, 500°C, and 550°C. Then the third layer of 20 multilayer electrodes was removed by a wet-etching method using nitric acid and hydrochloric acid, and the exposed surface of the multilayer electrodes was inspected with a microscope. Multilayer electrodes of the prior art consisting of a first layer 24 of aluminum, a second layer 25 of Ti, and a third layer 26 of aluminum were used. The electrodes of the prior art were annealed, etched, and inspected in the same manner as those of the present invention. The results of the inspection are shown in Table 1.

# 0 082 012

TABLE 1

| Twenty Electrodes | Fraction Defective | | |
|---|---|---|---|
| | 450°C | 500°C | 550°C |
| Prior Art | 0/20 | 20/20 | 20/20 |
| Present Invention | 0/20 | 0/20 | 20/20 |

As can be seen from Table 1, there were no defective electrodes in either the present invention or the prior art at an annealing temperature of 450°C. But at an annealing temperature of 500°C, the Ti second layer of all of the electrodes of the prior art disappeared, as determined with a microscope, whereas all of the electrodes of the present invention had no abnormal Ti second layer. At an annealing temperature of 550°C, however, the Ti second layer of all of the electrodes of both the present invention and the prior art disappeared.

Multilayer electrodes having the same construction as that of the above-mentioned electrodes, except that the second layer 25 was made of TiW, were formed. Then the multilayer electrodes were annealed, etched, and inspected in the above-mentioned manner. The results of the inspection are shown in Table 2.

TABLE 2

| Twenty Electrodes | Fraction Defective | | |
|---|---|---|---|
| | 450°C | 500°C | 550°C |
| Prior Art | 0/20 | 20/20 | 20/20 |
| Present Invention | 0/20 | 0/20 | 20/20 |

As can be seen from Table 2, at an annealing temperature of 450°C, all of the electrodes of both the present invention and the prior art had a normal TiW second layer while at an annealing temperature of 550°C, the TiW second layer of all of them disappeared. At an annealing temperature of 500°C, in all of the electrodes of the prior art, the TiW second layer did not entirely disappear but disappeared locally, thereby rendering the electrodes defective.

In a case where bipolar transistors having multilayer electrodes were heated at a temperature of 500°C for 30 minutes, the occurrence of emitter-base short-circuiting was checked under the following conditions. Multilayer electrodes 27, 28, and 29 for a bipolar transistor were formed in accordance with the above-mentioned formation process. A first layer 24 and a third layer 26 were made of aluminum-silicon alloys containing 0.5%, 1.0%, or 2.0% by weight of silicon. The thickness of the first layer 24 was 150 nm and that of the third layer 26 was 650 nm. The second layer 25 was made of TiW and had a thickness of 0, 10, 50, 100, or 150 nm. A voltage of 5.0 V was applied across the base electrode 27 and the emitter electrode 28 (Fig. 2C) of the obtained bipolar transistors.

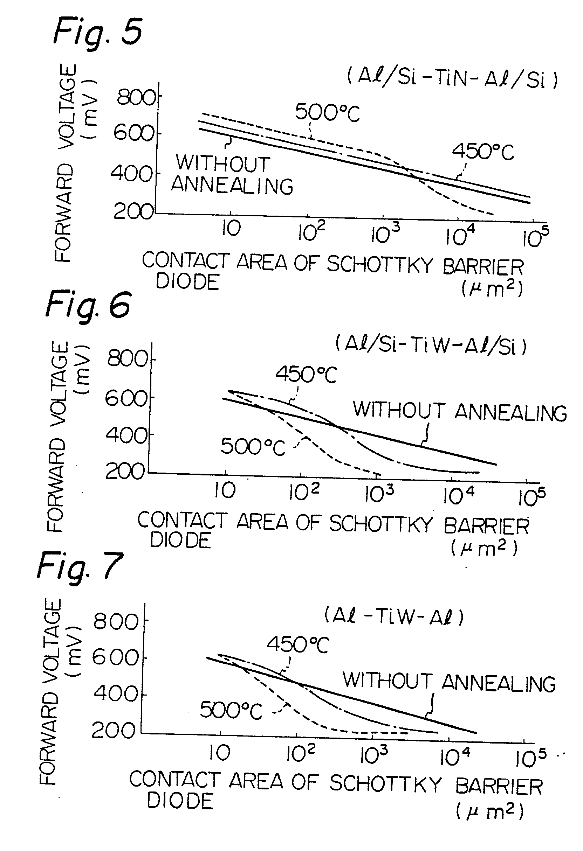

The results of the check are shown in Fig. 3. The abscissa of Fig. 3 represents the thickness of the TiW second layer and the ordinate represents the occurrence of emitter-base short-circuiting. As can be seen from Fig. 3, most of the bipolar transistors having multilayer electrodes comprising aluminum first and third layers (according to the prior art) are defective. The higher the silicon content of the aluminum-silicon first and third layers of multilayer electrodes according to the present invention, the lower the rate of occurrence of emitter-base short-circuiting.

The forward voltage ($V_F$) of the Schottky barrier diodes formed by a multilayer electrode was measured in the following manner. Schottky multilayer electrodes 30 (Fig. 2C) were formed at the same time as the above-mentioned bipolar transistors. Each of the Schottky barrier diodes had a contact area of approximately 300 $\mu m^2$. After the Schottky electrodes were heat-treated at 450°C for 30 minutes, the forward voltage of the Schottky barrier diodes was measured. The results are shown in Fig. 4.

As can be seen from Fig. 4, the higher the silicon content of the first and third layers of the multilayer electrodes, the higher the forward voltage. When the semiconductor devices are put to practical use, the forward voltage of the Schottky barrier diodes formed by the multilayer electrode of the prior art is not sufficient to maintain the stable operation of the devices. From this point of view, the Schottky barrier diodes formed by the multilayer electrode of the present invention are more preferable than those of the prior art.

The influence of annealing (i.e., of a heat-treatment) on the relationship between the contact area of Schottky barrier diodes and the forward voltage thereof was examined regarding the following three types

4

of Schottky multilayer electrodes having various contact areas. The first type of multilayer electrode 30 (Fig. 2C) consisted of a first layer 24 of an aluminum-silicon (1%) alloy, a second layer 25 of TiN, and a third layer 26 of an aluminum-silicon (1%) alloy. The second type of multilayer electrode 30 consisted of a first layer 24 and a third layer 26 of an aluminum-silicon (1%) alloy and a second layer 25 of TiW. The third type of multilayer electrode 30 (according to the prior art) consisted of a first layer 24 and a third layer 26 of aluminum and a second layer 25 of TiW. The Schottky barrier diodes having multilayer electrodes were either subjected to annealing (i.e., to a heat-treatment) at a temperature of 450°C and 500°C, respectively, for a period of 30 minutes or were not subjected to annealing. The forward voltage of the Schottky diodes having various contact areas was measured, and the results regarding the first, second, and third types of electrodes are shown in Figs. 5, 6, and 7, respectively.

As can be seen from Figs. 5, 6, and 7, the forward voltage stability of the Schottky barrier diodes having the prior art multilayer electrodes (Fig. 7) is lower than that of the Schottky barrier diodes having the multilayer electrodes of the present invention (Figs. 5 and 6). Furthermore, TiN is preferable to TiW as a material for the second layer.

It is possible to apply the present invention to an electrode of a metal-oxide semiconductor transistor or to a binder between a silicon chip and a support.

**Claims**

1. A multilayer electrode (1, 27, 28, 29, 30) of a semiconductor device comprising a first layer (2, 24) containing aluminium in contact with the surface of a silicon semiconductor substrate (5, 12), a second layer (3, 25) of a refractory metal or an alloy or compound thereof formed on the first layer, and a third layer (4, 26) containing aluminium formed on the second (3, 25) layer, characterised in that the third layer (4, 26) also contains silicon.

2. A multilayer electrode according to claim 1, in which the silicon in the third layer (4, 26) is present in an amount from 0.5% to 2.0% by weight.

3. A multilayer electrode according to claim 1 or 2, in which the first layer (2, 24) also contains silicon.

4. A multilayer electrode according to claims 1 or 3 in which the third and/or first layer contains copper or magnesium in addition to silicon.

5. A multilayer electrode according to any one of the preceding claims, in which the refractory metal is Ti, W, Mo, Zr, Cr, Hf, Nb, V, Ni, Pt, Ta or Pd.

6. A multilayer electrode according to any one of the preceding claims, in which the alloy of the refractory metal is TiW, TiMo or TiTa.

7. A multilayer electrode according to any one of the preceding claims, in which the compound of the refractory metal is TiN, TaN, ZiN, WN, TiC, TaC or HfN.

8. A method of making a multilayer electrode (1, 27, 28, 29, 30) of a semiconductor device comprising forming a first layer (2, 24) containing aluminium in contact with the surface of a silicon semiconductor substrate (5, 12) forming a second layer (3, 25) of a refractory metal or an alloy or compound thereof formed on the first layer, and forming a third layer (4, 26) on the second (3, 25) layer, characterised in that the third layer (4, 26) consists of an aluminium-silicon alloy.

**Patentansprüche**

1. Vielschichtelektrode (1, 27, 28, 29, 30) einer Halbleitervorrichtung, mit einer ersten Schicht (2, 24), die Aluminium in Berührung mit der Oberfläche eines Siliziumhalbleitersubstrats (5, 12) umfaßt, einer zweiten Schicht (3, 25) aus einem feuerfesten Metall oder einer Legierung oder einer Mischung davon, die auf der ersten Schicht gebildet ist, und eine dritten Schicht (4, 26), die Aluminium enthält, die auf der zweiten (3, 25) Schicht geformt ist, dadurch gekennzeichnet, daß die dritte Schicht (4, 26) ebenfalls Silizium enthält.

2. Vielschichtelektrode nach Anspruch 1, bei der das Silizium in der dritten Schicht (4, 26) in einer Menge von 0,5—2,0 Gewichts-% vorhanden ist.

3. Vielschichtelektrode nach Anspruch 1 oder 2, bei der die erste Schicht (2, 24) ebenfalls Silizium enthält.

4. Vielschichtelektrode nach den Ansprüchen 1 oder 3, bei der die dritte und/oder erste Schicht Kupfer oder Magnesium zusätzlich zu dem Silizium enthält.

5. Vielschichtelektrode nach einem der vorhergehenden Ansprüche, bei der das feuerfeste Metall Ti, W, Mo, Zr, Cr, Hf, Nb, V, Ni, Pt, Ta oder Pd ist.

6. Vielschichtelektrode nach einem der vorhergehenden Ansprüche, bei der die Legierung des feuerfesten Metalls TiW, TiMo oder TiTa ist.

7. Vielschichtelektrode nach einem der vorhergehenden Ansprüche, bei der die Verbindung des feuerfesten Metalls TiN, TaN, ZiN, WN, TiC, TaC oder HfN ist.

8. Verfahren zur Herstellung einer Vielschichtelektrode (1, 27, 28, 29, 30) einer Halbleitervorrichtung, mit Bilden einer ersten Schicht (2, 24), die Aluminium in Berührung mit der Oberfläche eines Siliziumhalbeitersubstrats (5, 12) umfaßt, Bilden einer zweiten Schicht (3, 25) aus feuerfestem Material oder einer Legierung oder einer Verbindung davon, die auf der ersten Schicht gebildet wird, und Bildung einer dritten Schicht (4, 26) auf der zweiten (3, 25) Schicht, dadurch gekennzeichnet, daß die dritte Schicht (4, 26) aus einer Aluminium-Silizium-Legierung besteht.

**Revendications**

1. Electrode à couches multiples (1, 27, 28, 29, 30) d'un composant à semi-conducteurs comportant une première couche (2, 24) contenant de l'aluminium, en contact avec la surface à substrat semi-conducteur en silicium (5, 12), une seconde couche (3, 25) d'un métal réfractaire ou d'un alliage ou d'un composé de métal réfractaire formée sur la première couche et une troisième couche (4, 26) contenant de l'aluminium, formée sur la seconde couche (3, 25), caractérisée en ce que la troisième couche (4, 26) contient également du silicium.

2. Electrode à couches multiples selon la revendication 1, dans laquelle le silicium de la troisième couche (4, 26) est présent dans une quantité allant de 0,5% à 2,0% en poids.

3. Electrode à couches multiples selon la revendication 1 ou 2, dans laquelle la première couche (2, 24) contient également du silicium.

4. Electrode à couches multiples selon la revendication 1 ou 3, dans laquelle la troisième et/ou la première couche contient du cuivre ou du magnesium en plus du silicium.

5. Electrode à couches multiples selon l'une quelconques des revendications précédentes, dans laquelle le métal réfractaire est TiW, Mo, Zr, Cr, Hf, Nb, V, Ni, Pt, Ta ou Pd.

6. Electrode à couches multiples selon l'une quelconques des revendications précédentes dans laquelle l'alliage du métal réfractaire est TiW, TiMo, ou TiTa.

7. Electrode à couches multiples selon l'une quelconques des revendications précédentes, dans laquelle le composé du métal réfractaire est TiN, TaN, ZiN, WN, TiC, TaC ou HfN.

8. Procédé de fabrication d'une électrode à couches multiples (1, 27, 28, 29, 30) d'un composant à semi-conducteurs consistant à former une première couche (24) contenant de l'aluminium, en contact avec la surface d'un substrat semi-conducteur en silicium (5, 12) à former une seconde couche (3, 25) d'un métal réfractaire ou d'un alliage ou d'un composé d'un métal réfractaire, formée sur la première couche et à former une troisième couche (4, 26) sur la second couche (3, 25), caractérisé en ce que la troisième couche (4, 26) consiste en un alliage d'aluminium-silicium.

0 082 012

Fig. 1

Fig. 3

OCCURENCE OF EMITTER-BASE SHOT-CIRCUITING (%)

Si 0%

Si 0.5%

Si:1.0%

Si 2.0%

THICKNESS OF TiW LAYER (nm)

Fig. 4

FORWARD VOLTAGE (mV)

Si
2.0%
1.0%
0.5%
0%

THICKNESS OF TiW LAYER (nm)

1

0 082 012

# Fig. 2 A

# Fig. 2 B

# Fig. 2 C

*Fig. 5*

( Aℓ/Si-TiN-Aℓ/Si )

500°C
450°C
WITHOUT ANNEALING

FORWARD VOLTAGE (mV)

800
600
400
200

10    10² 10³ 10⁴ 10⁵

CONTACT AREA OF SCHOTTKY BARRIER DIODE    ( μm² )

*Fig. 6*

( Aℓ/Si-TiW-Aℓ/Si )

450°C
WITHOUT ANNEALING
500°C

FORWARD VOLTAGE (mV)

800
600
400
200

10    10²    10³    10⁴    10⁵

CONTACT AREA OF SCHOTTKY BARRIER DIODE    ( μm² )

*Fig. 7*

( Aℓ-TiW-Aℓ )

450°C
WITHOUT ANNEALING
500°C

FORWARD VOLTAGE (mV)

800
600
400
200

10    10²    10³    10⁴    10⁵

CONTACT AREA OF SCHOTTKY BARRIER DIODE    ( μm² )